Europäisches Patentamt

European Patent Office

Office européen des brevets

(19)

(11) **EP 0 696 394 B1**

(12) **EUROPÄISCHE PATENTSCHRIFT**

(45) Veröffentlichungstag und Bekanntmachung des Hinweises auf die Patenterteilung:
**15.01.1997 Patentblatt 1997/03**

(21) Anmeldenummer: **94912451.5**

(22) Anmeldetag: **13.04.1994**

(51) Int Cl.6: **H03M 1/10**, H03M 1/46

(86) Internationale Anmeldenummer:
**PCT/DE94/00408**

(87) Internationale Veröffentlichungsnummer:
**WO 94/26034 (10.11.1994 Gazette 1994/25)**

(54) **VERFAHREN ZUR KOMPENSATION VON BAUTEILETOLERANZEN IN ANALOG-DIGITAL-KONVERTERN**

PROCESS FOR COMPENSATING COMPONENT TOLERANCES IN ANALOG-DIGITAL CONVERTERS

PROCEDE PERMETTANT DE COMPENSER LES TOLERANCES DES COMPOSANTS DANS DES CONVERTISSEURS ANALOGIQUES-NUMERIQUES

(84) Benannte Vertragsstaaten:
**DE FR GB IT**

(30) Priorität: **27.04.1993 DE 4313745**

(43) Veröffentlichungstag der Anmeldung:
**14.02.1996 Patentblatt 1996/07**

(73) Patentinhaber: **ROBERT BOSCH GMBH**
**70442 Stuttgart (DE)**

(72) Erfinder:
• **TENTEN, Wilfried**
  **D-72501 Gammertingen (DE)**
• **BOEHL, Eberhard**
  **D-72768 Reutlingen (DE)**
• **GANGEI, Arnd**
  **D-72800 Eningen (DE)**

(56) Entgegenhaltungen:
**EP-A- 0 064 147      EP-A- 0 360 919**

**Beschreibung**

STAND DER TECHNIK

Die Erfindung betrifft ein Verfahren zur Kompensation von Bauteiletoleranzen einer Reihe von gleichartigen Bauteilen, wie Kondensatoren, Widerständen, Stromquellen u.dgl. in Analog-Digital-Konvertern nach der Gattung des Hauptanspruches.

Die bei der Herstellung von Analog-Digital-Konvertern üblicherweise eingesetzten kurzkanaligen CMOS-Prozesse sind auf hohe Transistorpackungsdichte und hohe Schaltgeschwindigkeiten optimiert. Jedoch erfordert gerade im ASIC-Design die weitere Bearbeitung einer analogen Eingangsinformation in zunehmendem Maße hoch auflösende und auch genaue Analog-Digital-Konverter. Aufgrund der Prozeßführung sind nur in den seltensten Fällen hochgenaue analoge Komponenten, wie z.B. Widerstände und Kondensatoren, verfügbar. Damit muß zur Erzielung von Genauigkeiten jenseits der 8-Bit-Grenze ein Abgleichverfahren vorgesehen werden, wobei die Art des Abgleiches im wesentlichen die Qualität und Zuverlässigkeit des Konverters bestimmt. In Analog-Digital-Konvertern werden häufig binär gewichtete Kondensatorarrays verwendet. Ungenauigkeiten im Wichtungsverhältnis der Kapazitäten führen dabei zwangsläufig zu fehlerhaften Wandlungsergebnissen. Diese Fehler schlagen sich als differentielle Nichtlinearitäten (DNL) nieder, die häufig den spezifizierten Rahmen überschreiten. Beispielsweise kann ein 12-Bit-Konverter mit einer Genauigkeit von 1/2 oder 1/4 LSB angegeben werden, wobei bei Unstimmigkeiten im kapazitiven Array, das die oberen 8 Bit bedient, zu Fehlern von einigen 10 LSB führen kann.

Aus den folgenden druckschriftlichen Veröffentlichungen:

(1) LEE H.S., Hodges D:A., "Self-Calibration Technique for A/D converter", IEEE, CAS-30, pp. 188 - 190, Mar. 1983

(2) Tsukada T., Takagi K., Kita Y., Nagata M., "An Automatic Error Cancellation Technique for Higher Accuracy A/D Converters", IEEE, Journal of Solid-State-Circuits, Vol. SC-19, No. 2, pp. 266 - 268, Apr. 1984

(3) Matsuya Y., Akazawa Y., Iwata A., "High-Linearity and High-Speed CMOS 1-chip A/D, D/A Converter. All-Digital Linearity Error Correction (LECS)", Electronics and Communications in Japan, Part 2, Vol. 70, pp. 73 - 84, 1987

(4) McCreary .J.L., Gray P.R., "A High-Speed, All-MOS Successive Approximation Weighted Capacitor A/D Conversion Technique", ISSCC Dig. Tech. Papers, pp. 38 - 39, Feb. 1975

(5) McCreary J.L., Gray P.R., "All-MOS Charge Redistribution Analog-to-Digital Conversion Techniques-Part I", IEEE, SC-10, pp. 371 - 379, Dec. 1979

sind Korrekturverfahren für Kapazitätsarrays in Analog-Digital-Konvertern bekannt, die alle mit einem zusätzlichen Digital-Analog-Konverter arbeiten. Bei den bekannten Korrekturverfahren wird das Kondensatorarray im Gesamten korrigiert, nicht dagegen die einzelnen Kapazitäten unabhängig von den Kapazitätsabweichungen der anderen. Damit ist eine Neukalibrierung während des normalen Betriebes ohne längere Unterbrechung des Wandlungsvorganges nicht möglich.

Aus der EP 64 147 A3 ist bereits ein Analog-Digital-Konverter bekannt, bei dem eine Vielzahl von gleichartigen Kondensatoren, deren Kapazitätswert sich jeweils von Bauteil zu Bauteil halbiert, verwendet wird. Das Bauteil mit dem kleinsten Stellenwert ist doppelt vorhanden. Durch Anlegen von Potentialen wird ein vorbestimmtes Bauteil mit den übrigen Bauteile mit niedrigerem Stellenwert verglichen, indem das sich dann an den Kondensatoren einstellende Potential mit einem Bezugspotential verglichen wird. Dabei werden sukzessive alle Kondensatoren miteinander verglichen.

VORTEILE DER ERFINDUNG

Das erfindungsgemäße Kompensationsverfahren mit dem kennzeichnenden Merkmal des Hauptanspruches hat demgegenüber den Vorteil, daß durch die individuellen Korrekturen der einzelnen Bauteile, insbesondere Kondensatoren, unabhängig von den anderen Bauteilen eine Neukalibrierung jedes einzelnen Bauteiles während des normalen Betriebes möglich ist, wobei hierfür jeweils nur sehr kurzzeitige Unterbrechungen des Wandlungsvorganges erforderlich sind. Darüberhinaus führt die individuelle Kompensation von Toleranzen der einzelnen Bauteile insgesamt zu einer über den gesamten Bereich sehr präzisen Analog-Digital-Wandlung.

Durch die in den Unteransprüchen aufgeführten Maßnahmen sind vorteilhafte Weiterbildungen und Verbesserungen des im Hauptanspruch angegebenen Kompensationsverfahrens möglich.

Besonders vorteilhaft ist die Wiederholung des Verfahrens bei vertauschtem ersten und zweiten Potential, die Durchführung einer Mittelwertbildung der beiden ermittelten Korrekturspannungen und die Speicherung des Mittelwertes als Korrekturwert. Eventuelle Ungenauigkeiten des Mittenpotentials werden dadurch automatisch kompensiert, so daß die Bildung des Mittenpotentials auch relativ ungenau erfolgen kann und keinen Einfluß auf die Präzision der Analog-Digital-Wandlung ausübt.

Zweckmäßigerweise wird für jedes Bauteil in entsprechender Weise ein Korrekturwert ermittelt und gespeichert, vorzugsweise in digitaler Form.

Eine vorteilhafte Ausführung des Kompensationsabgleiches durch den Komparator kann dadurch erfolgen, daß die Korrekturspannung als Wechselsignalfolge mit geringem Spannungshub ausgebildet ist und daß ein entsprechender Ausgangssignalwechsel am Komparator als erreichter Abgleich gewertet wird. Um eine ständige Nachkalibrierung während des normalen Betriebes des Analog-Digital-Konverters zu erreichen, erfolgt jeweils während Betriebsunterbrechungen des Analog-Digital-Konverters nacheinander eine Nachkalibrierung der Korrekturwerte, wobei während jeder Betriebsunterbrechung wenigstens ein Korrekturwert nachkalibriert wird. Es ist selbstverständlich auch möglich, sämtliche Korrekturwerte während einer Arbeitspause oder Betriebsunterbrechung oder auf Anforderung nachzukalibrieren.

Um beim Nachkalibrierungsprozeß signifikante Unterschiede der neu ermittelten Korrekturwerte auszugleichen, ist in vorteilhafter Weise ein Glättungsverfahren zur Dämpfung solcher Unterschiede nach Art eines Tiefpasses vorgesehen. Starke Abweichungen, die möglicherweise auf Störungen beruhen, können dadurch verhindert werden.

Die gespeicherten Korrekturwerte werden beim bestimmungsgemäßen Betrieb des Analog-Digital-Konverters nacheinander bei jedem Wandlungsschritt entsprechend berücksichtigt, so daß jeder Wandlungsschritt mit höchstmöglicher Präzision durchgeführt wird.

Um definierte Anfangsbedingungen zu erreichen, werden vor der Ermittlung oder Nachkalibrierung von Korrekturwerten alle als Kondensatoren ausgebildeten Bauteile entladen. Hierzu werden insbesondere beide Anschlüsse auf das Mittenpotential gelegt.

ZEICHNUNG

Ein Ausführungsbeispiel der Erfindung ist in der Zeichnung dargestellt und in der nachfolgenden Beschreibung näher erläutert. Es zeigen:

Figur 1 ein Blockschaltbild eines Analog-Digital-Konverters mit einer Kompensationseinrichtung zur Kompensation von Toleranzen eines Kondensatorarrays und

Figur 2 das Kondensatorarray in Verbindung mit erforderlichen Schaltern zur Durchführung der Analog-Digital-Wandlung und der Kompensation.

BESCHREIBUNG DES AUSFÜHRUNGSBEISPIELES

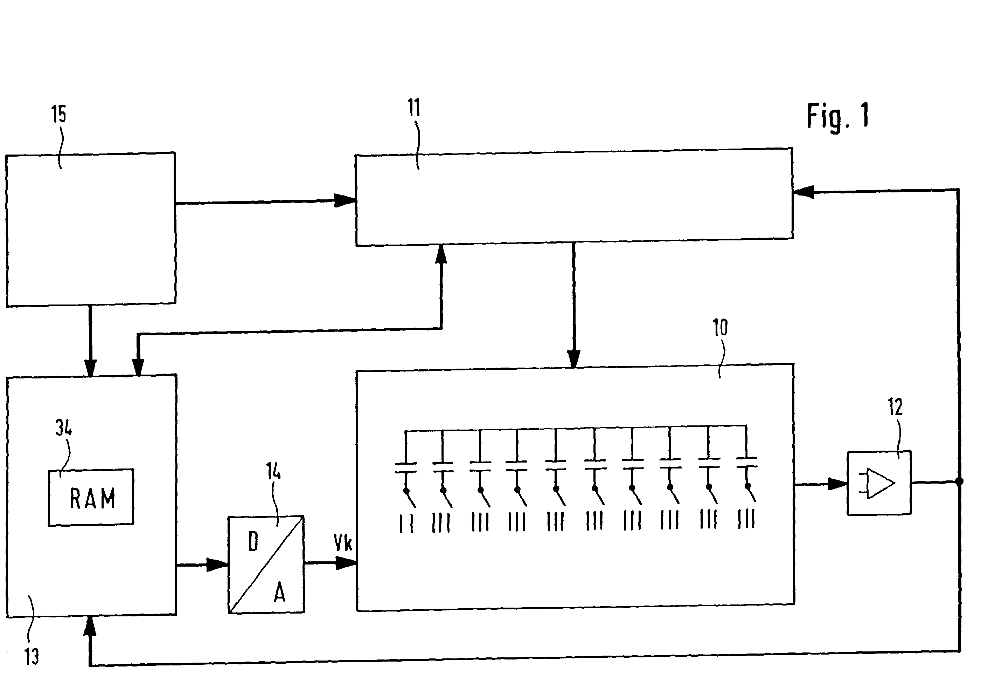

Bei dem in Figur 1 dargestellten Analog-Digital-Konverter wird ein mit einer Vielzahl von Schaltern versehenes Kondensatorarray 10 von einem Steuerwerk 11 (SAR-Register und Array-Ansteuerung) gesteuert. Das Kondensatorarray 10 weist ausgangsseitig einen Komparator 12 auf, der sowohl in das Steuerwerk 11, wie auch in ein Kalibrierungs- und Korrekturmodul 13 eingreift, im folgenden vereinfacht als Modul 13 bezeichnet. Dieses Modul 13 greift über einen Korrektur-Digital-Analog-Konverter 14 in das Kondensatorarray 10 ein und liefert insbesondere eine Korrekturspannung Vk, wie später noch ausführlicher erläutert wird. Dieser Korrektur-Digital-Analog-Konverter 14 wird im folgenden vereinfacht als D/A-Konverter 14 bezeichnet. Eine zentrale Steuereinheit 15, die in nicht dargestellter, an sich bekannter Weise einen Clock-Dekoder enthält, steuert die zentralen Funktionen des Steuerwerkes 11 und des Moduls 13. Darüberhinaus beeinflussen sich das Steuerwerk 11 und das Modul 13 gegenseitig.

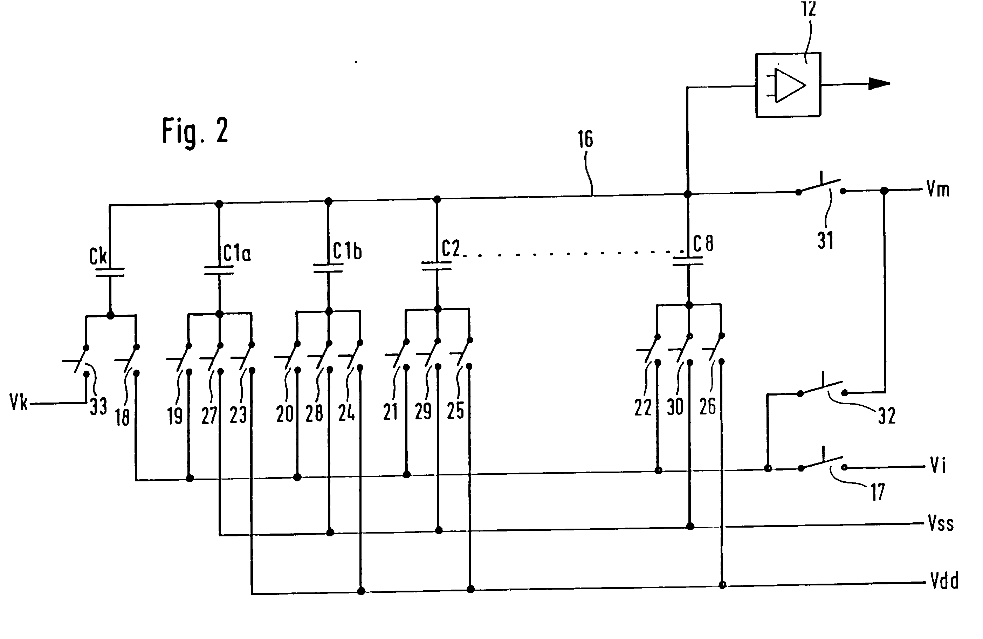

In Figur 2 ist das Kondensatorarray 10 detaillierter dargestellt.

Es besteht im wesentlichen aus zehn Kondensatoren, nämlich einem Korrekturkondensator Ck und neun Arbeitskondensatoren C1a, C1b sowie C2 bis C8. Der Kondensator C8 weist die höchste Kapazität auf, wobei jeweils der nächste Kondensator eine halb so große Kapazität besitzt. Die beiden Kondensatoren C1a und C1b besitzen gleiche Kapazitätswerte, die die kleinsten Kapazitätswerte darstellen.

Alle Kondensatoren sind an eine gemeinsame Mittenleitung 16 angeschlossen, die über den Komparator 12 mit dem Steuerwerk 11 und dem Modul 13 verbunden ist. Die Kondensatoren C3 bis C7 sind zur Vereinfachung nicht dargestellt. Die Zahl der Arbeitskondensatoren bestimmt die Genauigkeit des Analog-Digital-Konverters, also dessen Bit-Zahl.

Die in digitale Werte umzuwandelnde analoge Eingangsspannung Vi wird über einen steuerbaren Schalter 17 dem Kondensatorarray 10 zugeführt, wobei dieser Schalter 17 über weitere steuerbare Schalter 18 bis 22 mit allen Kondensatoren verbunden ist (selbstverständlich auch über weitere nicht dargestellte Schalter mit den nicht dargestellten Kondensatoren C3 bis C7). Ein oberes Spannungspotential Vdd ist über weitere Schalter 23 bis 26 an die Arbeitskondensatoren C1a bis C8 anlegbar. Schließlich ist noch ein unteres Potential Vss über Schalter 27 bis 30 an die Arbeitskondensatoren C1a bis C8 anlegbar. Ein Mittenpotential Vm, das einen Mittelwert zwischen den Potentialen Vdd und Vss darstellt, kann über einen weiteren Schalter 31 an die Mittenleitung 16 und über einen weiteren Schalter 32 an diejenige Leitung angelegt werden, der über den Schalter 17 die analoge Eingangsspannung Vi zuführbar ist. Die Korrekturspannung Vk kann dem Korrekturkondensator Ck über einen Schalter 33 zugeführt werden. Anstelle der dargestellten Anordnung kann diesem Korrekturkondensator Ck die Mittenspannung Vm über den Schalter 18 auch separat zugeführt werden, d.h., eine Mittenspannung, die unabhängig von der an der Mittenleitung 16 anlegbaren Mittenspannung erzeugt wird. Dies wird in der Praxis häufig so realisiert.

Die Arbeitsweise eines derartigen Analog-Digital-Konverters ist mit Ausnahme der noch zu erläuternden Kompensation von Bauteiletoleranzen aus dem eingangs angegebenen Stand der Technik bekannt, so daß nur kurz darauf eingegangen werden soll. Zunächst wird durch Schließen der Schalter 17, 19 bis 22 die Eingangsspannung Vi an alle Arbeitskondensatoren C1a bis C8 gelegt, während an den gegenüberliegenden Anschlüssen durch Schließen des Schalters 31 das Mittenpotential Vm liegt. Nun werden alle Schalter wieder geöffnet und dann die Schalter 26 sowie 27 bis 29 geschlossen. Dadurch liegt am Kondensator C8 mit der höchsten Kapazität die obere Spannung Vdd und an den übrigen Kondensatoren die untere Spannung Vss. Wenn dadurch an der Mittenleitung 16 ein gegenüber dem vorher anliegenden Mittenpotential Vm höheres Potential anliegt, so spricht der Komparator 12 an, der Schalter 26 wird wieder geöffnet und der Schalter 30 wird für die übrige Wandlungszeit geschlossen. Nun wird an den nächst niedrigeren Kondensator C7 (nicht dargestellt) die Spannung Vdd anstelle der Spannung Vss gelegt. Auch hier wird wieder beobachtet, ob der Komparator 12 anspricht oder nicht. Falls er nicht anspricht bleibt die Spannung Vdd an diesem Kondensator C7 angelegt und der nächste Kondensator C6 wird anstelle des Potentiales Vss mit dem Potential Vdd beaufschlagt. Jedesmal wird geprüft, ob der Komparator 12 anspricht, und falls er anspricht, so wird die Spannung Vdd wieder abgetrennt und der zugehörige Schalter nach Vss wird - wie bereits erläutert - für die weitere Wandlungszeit festgelegt, im anderen Falle bleibt sie am jeweiligen Kondensator angelegt. Ist dieser Vorgang für alle Kondensatoren C1a bis C8 durchgeführt, so ergeben die Schalterstellungen der mit dem Potential Vdd beaufschlagbaren Schalter das digitale Wort, das der analogen Eingangsspannung Vi entspricht. Dieses digitale Wort wird über den Komparator 12 entsprechend den jeweiligen Schritten ins Steuerwerk 11 gegeben und kann von dort ausgegeben werden.

Die Genauigkeit der beschriebenen Analog-Digital-Wandlung ist insbesondere durch die Genauigkeit der Kapazitätswerte der Kondensatoren bestimmt. Da die gewünschte Genauigkeit in der Praxis mit vertretbarem Aufwand niemals erreicht werden kann, erfolgt nun eine Kompensation der Toleranzen dieser Kondensatoren. Hierzu ist der Schalter 17 dauernd geöffnet, da die analoge Eingangsspannung für diesen Vorgang nicht relevant ist. Zunächst werden alle Kondensatoren entladen. Dies erfolgt durch Schließen der Schalter 18 bis 22 sowie 31 und 32. Hierdurch liegt an beiden Anschlüssen aller Kondensatoren das Mittenpotential Vm. Dieses stellt das Mittenpotential zwischen den Potentialen Vdd und Vss dar und kann beispielsweise durch einen Spannungsteiler gebildet werden. Die Genauigkeit spielt dabei keine Rolle, wie später noch erläutert wird.

Nun werden alle Schalter wieder geöffnet und dann die Schalter 27 bis 29 sowie 26 geschlossen. Hierdurch liegt am Kondensator C8 mit der größten Kapazität die höhere Spannung Vdd und an den übrigen Arbeitskondensatoren C1a bis C7 die niedrigere Spannung Vss an. Würden alle Kapazitätswerte exakt stimmen, so läge jetzt an der Mittenleitung 16 exakt das Mittenpotential Vm, da die Summe der Kapazitätswerte der Kondensatoren C1a bis C7 der Kapazität von C8 entsprechen. Nur bei perfektem, binär gewichtetem Kapazitäts-Arrangement könnte eine solche exakte Ladungsteilung erreicht werden. Jede Streuung der Kapazitätswerte der Kondensatoren des Arrays führt zwangsläufig zu einer Abweichung vom idealen Mittenpotential. Diese Abweichung wird mit Hilfe des Komparators 12 festgestellt, der das sich auf der Mittenleitung 16 einstellende Potential mit dem Mittenpotential Vm vergleicht. Nachdem ein Wandlungszyklus vollständig durchgeführt ist, wird dem sich eingestellten Mittenpotential ein Wechselsignal mit geringem Spannungshub, beispielsweise ± 1/2 LSB, überlagert. Wird am Ausgang des Komparators 12 ein entsprechendes Wechselsignal festgestellt, so ist der Abgleich gefunden. Andernfalls liegt der Ausgang auf einem der beiden möglichen Signalpegel, wodurch über das Modul 13 ein Korrektursignal erzeugt wird, das im D/A-Konverter 14 in eine analoge Korrekturspannung Vk umgewandelt und dem Korrekturkondensator Ck über den geschlossenen Schalter 33 zugeführt wird. Diese Korrekturspannung Vk wird so lange variiert, bis der Abgleich gefunden ist. Das entsprechende Korrektursignal wird als digitaler Korrekturwert in einem Speicher 34 des Moduls 13 als provisorischer Korrekturwert festgehalten.

Nun werden die Schalter 27 bis 29, sowie 26 geöffnet und dafür die Schalter 23 bis 25 sowie 30 geschlossen. Dadurch liegt am Kondensator C8 nunmehr die Spannung Vss und an den übrigen Kondensatoren die Spannung Vdd. Es erfolgt dann ein weiterer entsprechender Abgleich und der ermittelte Korrekturwert wird als zweiter provisorischer Korrekturwert festgehalten. Wäre das als Vergleichsspannung vom Komparator 12 gewertete Mittenpotential Vm das exakte ideale Mittenpotential, so wären die beiden provisorischen Korrekturwerte gleich. Bei einer Abweichung vom idealen Mittenpotential weichen auch die provisorischen Korrekturwerte voneinander ab. Nun braucht lediglich der Mittelwert zwischen den beiden provisorischen Korrekturwerten gebildet und dieser Mittelwert als exakter Korrekturwert für den höchsten Kondensator C8 abgespeichert werden. Auf diese Weise werden Abweichungen der Spannung Vm von der idealen Mittenspannung automatisch kompensiert.

Die beschriebene Prozedur wird nun für die übrigen Arbeitskondensatoren C1a bis C7 entsprechend durchgeführt, so daß am Ende neun Korrekturwerte vorliegen, die unter der dem zu korrigierenden Arbeitskondensator zugehörigen Adresse im Speicher 34 gespeichert werden.

Nach der durchgeführten Kalibrierung schaltet das Steuerwerk 11, das u.a. die Schaltersteuerung im Kondensatorarray 10 bewirkt, den Analog-Digital-Wandler in den Betriebszustand "wandeln". Während dieses Zustandes arbeitet er in der eingangs beschriebenen Weise. Dabei kann über eine interne zeitliche Steuerung oder bei Bedarf von außen eine Nachkalibrierung angefordert werden. Eine solche Nachkalibrierung erfolgt sequentiell, beginnend mit dem obersten Bit, jedoch nur jeweils die Nachkalibrierung eines Kondensators pro Anforderung. Damit wird der Wandlungszyklus nur kurzzeitig unterbrochen. Es ist selbstverständlich auch prinzipiell möglich zyklisch oder bei Anforderung eine komplette Nachkalibrierung durchzuführen. Für den Nachkalibrierungsprozeß ist ein Glättungsalgorithmus vorgesehen, der signifikante Unterschiede im jeweils gefundenen Korrekturwert, ähnlich einer Tiefpaßfunktion, dämpft. Hierdurch wird verhindert, daß beispielsweise durch Störungen gebildete extreme Abweichungen nicht gravierend im Wandlungsprozeß wirksam werden können.

Es sei noch festgehalten, daß die Erfindung selbstverständlich nicht auf die Kalibrierung bzw. Kompensation von Toleranzen von Kondensatoren beschränkt ist. Eine entsprechende Kompensation kann auch für andere in einem Array angeordnete Bauteile eines Analog-Digital-Konverters erfolgen, beispielsweise Widerstände, Stromquellen o. dgl.. Beispielsweise bei Widerständen entspricht dabei der Widerstand mit dem höchsten Leitwert dem Kondensator mit der höchsten Kapazität.

Im folgenden wird noch zur zusätzlichen Erläuterung das beschriebene Kalibrierverfahren in seiner mathematischen Form dargestellt.

Die Korrekturspannung Vk, die im Falle einer idealen Mittenspannung Vm zur Kompensation gebildet wird beschreibt die folgende Gleichung (1):

$$Vk = \frac{Vm}{Ck} \left( \sum_{j=0}^{i-1} \Delta C(j) - \Delta C(i) + Ck \right) \qquad (1)$$

Dabei ist C(i) die zu kalibrierende Kapazität, C(j) sind alle Kapazitäten mit geringerer Wichtung und Ck ist die Korrektur-Kapazität. Der $\Delta$-Vorsatz bedeutet dabei jeweils die Abweichung vom idealen Wert.

Die folgende Gleichung (2) beschreibt die sich ergebende Korrekturspannung Vk' unter Berücksichtigung einer Abweichung von Vm vom Idealwert und bei Beschaltung der obersten Kapazität C8 an Vdd und der übrigen Kapazitäten an Vss:

$$Vk' = \frac{Vm}{Ck} \left( \sum_{j=0}^{i-1} \Delta C(j) - \Delta C(i) + Ck \right) + \left( \sum_{j=0}^{i} (C(j) + \Delta C(j)) + Ck \right) \frac{\Delta Vm}{Ck} \qquad (2)$$

Die folgende Gleichung (3) beschreibt die sich ergebende Korrekturspannung Vk'' bei inverser Beschaltung der Kapazitäten (Vertauschung von Vdd und Vss):

$$(3)$$

$$Vk'' = Vdd - \frac{Vm}{Ck} \left( \sum_{j=0}^{i-1} \Delta C(j) - \Delta C(i) + Ck \right) + \left( \sum_{j=0}^{i} (C(j) + \Delta C(j)) + Ck \right) \frac{\Delta Vm}{Ck}$$

Der Mittelwert aus den Gleichungen (2) und (3) führt zur korrekten Korrekturspannung Vk gemäß der Gleichung (4), mit der der Korrekturkondensator Ck geladen wird:

$$Vk = \frac{Vk' - Vk''}{2} + \frac{Vdd}{2} \tag{4}$$

Wie bereits ausgeführt, wird das dieser Spannung zugeordnete digitale Wort im Speicher 34 unter der Adresse des jeweils kalibrierten Kondensators gespeichert. Damit steht das dem jeweiligen Bit zugehörige Korrekturwort stets zur Verfügung. Die dazu gehörige Korrekturspannung wird im Wandlerbetrieb in der jeweiligen Bit-Stufe vorher dem Korrekturalgorithmus zugeführt, der durch die folgenden Gleichungen (5) bis (7) beschrieben ist:

$$V\,(Reg\,(i,\,high)) = -\sum_{j=i}^{n-1} (\overline{Bj} \times (V\,(k,\,j) - \sum_{v=j+1}^{n-1} (\frac{Vk\,(v)}{2^{v-i}}))) \tag{5}$$

$$V\,(Reg\,(i,\,low)) = \sum_{j=i}^{n-1} (Bj \times (V\,(k,\,j) - \sum_{v=j+1}^{n-1} (\frac{Vk\,(v)}{2^{v-i}}))) \tag{6}$$

$$V\,(Korr,\,i) = \frac{V\,(Reg\,(i+1,\,high)) + V\,(Reg\,(i+1,\,low))}{2} + Vk\,(i) \tag{7}$$

Dabei ist V (Reg (i, high)) die gewichtete Summe der Korrekturspannungen, für die der Komparator bisher mit dem Ausgangspegel HIGH entschieden hat. Dieser Wert wird in einem Hilfsregister des Moduls 13 gespeichert. V (Reg (i, low)) ist die gewichtete Summe der Korrekturspannungen, für die der Komparator 12 bisher mit dem Ausgangspegel LOW entschieden hat. Dieser Wert wird in einem Arbeitsregister, beispielsweise im Speicher 34 gespeichert. Das äquivalente Digitalwort wird zwischengespeichert, und wenn der Korrekturwert als gültig anerkannt wird, wird das Wort endgültig im Speicher 34 gespeichert. V (Korr, i) ist die berechnete Korrekturspannung zur Komparatorentscheidung beim Bit i. n ist die Anzahl der Bits. Bj und $\overline{Bj}$ lassen die Komparatorentscheidung des Bits j einfließen:

Bei der Bewertung von Cj war

der Komparator low:      Bj = 0 und $\overline{Bj}$ = 1
der Komparator high:    Bj = 1 und $\overline{Bj}$ = 0.

## Patentansprüche

1. Verfahren zur Kompensation von Bauteiletoleranzen einer Reihe von gleichartigen Bauteilen (C1a bis C8), wie Kondensatoren, Widerständen, Stromquellen, in Analog-Digital-Konvertern die an einer gemeinsamen Leitung angeschlossen sind, und deren elektrischer Wert sich jeweils von Bauteil zu Bauteil halbiert, wobei das Bauteil mit dem kleinsten Stellenwert (C1a, C1b) doppelt vorhanden ist, wobei ein vorbestimmtes Bauteil mit den übrigen Bauteilen mit niedrigerem Stellenwert verglichen wird, indem Potentiale an die Bauteile angelegt werden und sich dabei einstellende Potentiale durch einen Komparator (12) mit einem Bezugspotential verglichen werden, dadurch gekennzeichnet, daß an wenigstens eines der Bauteile (C8) ein erstes Potential (Vdd) und an die übrigen Bauteile mit niedrigeren Stellenwerten (C1a bis C7) ein zweites Potential (Vss) angelegt wird, daß der Komparator (12) prüft, ob an der gemeinsamen Leitung (16) das Mittenpotential (Vm) zwischen den beiden Potentialen (Vdd, Vss) anliegt, daß ein zusätzlich an der gemeinsamen Leitung (16) angeschlossenes Korrekturbauteil (Ck) mit einer veränderbaren Korrekturspannung (Vk) beaufschlagt wird, die abgeglichen wird, bis der Komparator (12) an der gemeinsamen Leitung (16) das Mittenpotential (Vm) feststellt, und daß die ermittelte Korrekturspannung (Vk) als Korrekturwert gespeichert wird.

2. Verfahren nach Anspruch 1, gekennzeichnet durch eine Wiederholung des Verfahrens bei vertauschtem ersten und zweiten Potential (Vdd, Vss), die Durchführung einer Mittelwertsbildung der beiden ermittelten Korrekturspannungen und die Speicherung des Mittelwertes als Korrekturwert.

3. Verfahren nach Anspruch 1 oder 2, dadurch gekennzeichnet, daß für jedes Bauteil (Cla bis C8) in entsprechender Weise ein Korrekturwert ermittelt und gespeichert wird.

4. Verfahren nach Anspruch 3, dadurch gekennzeichnet, daß jeweils während einer Betriebsunterbrechung des Analog-Digital-Konverters nacheinander eine Nachkalibrierung der Korrekturwerte erfolgt, wobei während jeder Betriebsunterbrechung wenigstens ein Korrekturwert nachkalibriert wird.

5. Verfahren nach Anspruch 3 oder 4, dadurch gekennzeichnet, daß jeweils alle Korrekturwerte während einer Arbeitspause oder auf Anforderung nachkalibriert werden.

6. Verfahren nach einem der vorhergehenden Ansprüche, dadurch gekennzeichnet, daß die Korrekturwerte in digitaler Form abgespeichert werden.

7. Verfahren nach einem der vorhergehenden Ansprüche, dadurch gekennzeichnet, daß die Korrekturspannung (Vk) als Wechselsignalfolge mit geringem Spannungshub ausgebildet und in dieser Form dem Komparator (12) als Vergleichsspannung zugeführt wird, und daß ein entsprechender Ausgangssignalwechsel am Komparator (12) als erreichter Abgleich gewertet wird.

8. Verfahren nach einem der vorhergehenden Ansprüche, dadurch gekennzeichnet, daß ein Glättungsverfahren zur Dämpfung von signifikanten Unterschieden bei nachkalibrierten Korrekturwerten nach Art eines Tiefpasses durchgeführt wird.

9. Verfahren nach einem der vorhergehenden Ansprüche, dadurch gekennzeichnet, daß die gespeicherten Korrekturwerte beim bestimmungsgemäßen Betrieb des Analog-Digital-Konverters nacheinander bei jedem Wandlungsschritt entsprechend berücksichtigt werden.

10. Verfahren nach einem der vorhergehenden Ansprüche, dadurch gekennzeichnet, daß als gleichartige Bauteile (Cla bis C8) und als Korrekturbauteil (Ck) Kondensatoren eingesetzt werden.

11. Verfahren nach Anspruch 10, dadurch gekennzeichnet, daß vor der Durchführung der Nachkalibrierung von Korrekturwerten alle Kondensatoren (Ck, C1a bis C8) entladen werden.

12. Verfahren nach Anspruch 11, dadurch gekennzeichnet, daß zur Entladung der Kondensatoren (Ck, C1a bis C8) jeweils beide Anschlüsse auf das Mittenpotential (Vm) gelegt werden.

## Claims

1. Method for the compensation of component tolerances of a number of similar components (C1a to C8), such as capacitors, resistors, current sources, in analog-to-digital converters which are connected to a common line, and whose electric value is in each case halved from component to component, the component with the smallest place value (C1a, C1b) being present twice, a predetermined component being compared with the remaining components of lower place value in that potentials are applied to the components and potentials appearing in the process are compared by a comparator (12) with a reference potential, characterized in that a first potential (Vdd) is applied to at least one of the components (C8) and a second potential (Vss) is applied to the remaining components with lower place values (C1a to C7), in that the comparator (12) checks whether on the common line (16) the mid-potential (Vm) between the two potentials (Vdd, Vss) is present, in that there is applied to a correction component (Ck) which is in addition connected to the common line (16) a variable correction voltage (Vk) which is adjusted until the comparator (12) determines the mid-potential (Vm) on the common line (16), and in that the determined correction voltage (Vk) is stored as correction value.

2. Method according to Claim 1, characterized by a repetition of the method width interchanged first and second

EP 0 696 394 B1

potential (Vdd, Vss), the implementation of a mean-value formation of the two determined correction voltages and the storage of the mean value as correction value.

3. Method according to Claim 1 or 2, characterized in that a correction value is determined and stored in a corresponding manner for each component (C1a to C8).

4. Method according to Claim 3, characterized in that a recalibration of the correction values is performed in each case during an operational interruption of the analog-to-digital converter one after the other, at least one correction value being recalibrated during each operational interruption.

5. Method according to Claim 3 or 4, characterized in that in each case all correction values are recalibrated during a break in the work or on demand.

6. Method according to one of the preceding claims, characterized in that the correction values are stored in digital form.

7. Method according to one of the preceding claims, characterized in that the correction voltage (Vk) is formed as changing signal sequence with small voltage change and is fed in this form to the comparator (12) as comparison voltage, and in that a corresponding output signal change at the comparator (12) is evaluated as achieved adjustment.

8. Method according to one of the preceding claims, characterized in that a smoothing method is carried out for damping significant differences in the case of recalibrated correction values, in the manner of a lowpass filter.

9. Method according to one of the preceding claims, characterized in that, during proper operation of the analog-to-digital converter, the stored correction values are accordingly taken into account one after the other during each conversion step.

10. Method according to one of the preceding claims, characterized in that capacitors are used as similar components (C1a to C8) and as correction component (Ck).

11. Method according to Claim 10, characterized in that all capacitors (Ck, C1a to C8) are discharged before the recalibration of correction values is carried out.

12. Method according to Claim 11, characterized in that, in order to discharge the capacitors (Ck, C1a to C8), in each case both connections are connected to the mid-potential (Vm).

**Revendications**

1. Procédé pour compenser les tolérances de composants d'une série de composants de même type (C1a...C8), tels que des condensateurs, des résistances, des sources de courant dans des convertisseurs analogiques/numériques reliés à une ligne commune et dont la valeur électrique diminue de moitié d'un composant à l'autre, le composant correspondant à la plus petite valeur de réglage (C1a, C1b) étant doublé, et un composant prédéterminé étant comparé aux autres composants ayant une valeur de réglage plus faible, en appliquant des potentiels aux composants et en comparant les potentiels qui s'établissent à l'aide d'un comparateur (12) avec un potentiel de référence,
caractérisé en ce qu'
à au moins l'un des composants (C8) on applique un premier potentiel (Vdd) et aux autres composants à valeur de réglage plus faible (C1a...C7) on applique un second potentiel (Vss), le comparateur (12) vérifie si le potentiel moyen (Vm) appliqué à la ligne commune (16) se trouve entre les deux potentiels (Vdd, Vss), puis on applique une tension de correction variable (Vk) à un composant de correction (Ck) branché en plus sur la ligne commune (16), et on compense jusqu'à ce que le comparateur (12) constate le potentiel moyen (Vm) sur la ligne commune (16) et la tension de correction (Vk), obtenue est enregistrée comme valeur de correction.

2. Procédé selon la revendication 1,
caractérisé en ce qu'
on répète le procédé en échangeant le premier et le second potentiel (Vdd, Vss), on forme la valeur moyenne des deux tensions de correction obtenues et on enregistre cette valeur moyenne comme valeur de correction.

3.   Procédé selon la revendication 1 ou 2,
     caractérisé en ce que
     pour chaque composant (C1a...C8) on détermine et on enregistre une valeur de correction de manière correspondante.

4.   Procédé selon la revendication 3,
     caractérisé en ce que
     chaque fois pendant une interruption de fonctionnement du convertisseur analogique/numérique on effectue successivement un nouveau calibrage des valeurs de correction et pendant chaque interruption de fonctionnement, on effectue un nouveau calibrage d'au moins une valeur de correction.

5.   Procédé selon la revendication 3 ou 4,
     caractérisé en ce que
     on effectue un nouveau calibrage chaque fois de toutes les valeurs de correction pendant une pause de travail ou à la demande.

6.   Procédé selon l'une des revendications précédentes,
     caractérisé en ce que
     les valeurs de correction sont mises en mémoire sous forme numérique.

7.   Procédé selon l'une des revendications précédentes,
     caractérisé en ce que
     la tension de correction (Vk) est réalisée sous la forme d'une suite de signaux alternés à faible excursion de tension qui est appliquée sous cette forme au comparateur (12) comme tension de comparaison et en ce qu'on exploite comme compensation obtenue, une variation correspondante du signal de sortie sur le comparateur (12).

8.   Procédé selon l'une des revendications précédentes,
     caractérisé en ce qu'
     on exécute un procédé de lissage pour amortir les différences significatives lors d'un nouveau calibrage des valeurs de correction en procédant à la manière d'un filtre passe-bas.

9.   Procédé selon l'une des revendications précédentes,
     caractérisé en ce qu'
     à chaque étape de conversion on tient compte successivement des valeurs de correction mises en mémoire pour un fonctionnement tel que défini du convertisseur analogique/numérique.

10.  Procédé selon l'une des revendications précédentes,
     caractérisé en ce que
     comme composant de même type (C1a...C8) et comme composant de correction (Ck) on utilise des condensateurs.

11.  Procédé selon la revendication 10,
     caractérisé en ce qu'
     avant d'exécuter un nouveau calibrage des valeurs de correction, on décharge tous les condensateurs (Ck, C1a... C8).

12.  Procédé selon la revendication 11,
     caractérisé en ce que
     pour décharger les condensateurs (Ck, C1a...C8), on applique chaque fois les deux bornes au potentiel moyen (Vm).

Fig. 1

Fig. 2

EP 0 696 394 B1